# EUROPEAN PATENT APPLICATION

(11) **EP 4 553 677 A1**
(43) Date of publication of application: **14.05.2025**
(21) Application number: 24212459.2
(22) Date of filing: 12.11.2024
(51) Int. Cl.: G06F 16/901, G06F 16/903

(54) **SYSTEMS AND METHODS FOR AIRCRAFT DIGITAL TWIN MANAGEMENT AND QUERY**

(30) Priority: 13.11.2023 US 202318507753
(71) Applicant: General Electric Company, Cincinnati, Ohio 45215 (US)
(72) Inventor: SHIV KUMAR, Vijay, Niskayuna, 12309 (US); AGGOUR, Kareem Sherif, Niskayuna, 12309 (US); CUDDIHY, Paul Edward, Ballston Lake (US); ROMER, Michael Vincent, Austin, 78759 (US); GABALDON ROYVAL, Alfredo, Clifton Parks (US); DIXIT, Sharad, Schenectady, 12345 (US); MILLER, David Carl, Edmond (US); KUSNADI, Teddy, Edmond (US)
(74) Representative: Openshaw & Co.

(57) **Abstract**

Systems, apparatus, computer-readable medium, and associated methods to manage a network of digital twins are disclosed. An example apparatus includes memory circuitry to store a plurality of snapshots (600), each snapshot (600) including a plurality of digital twin models (101-132, 201) interconnected by a plurality of connections, the plurality of digital twin models (101-132, 201) including a first digital twin model (101-132, 201) of a first asset and a second digital twin model (101-132, 201) of a second asset, the plurality of connections including a first connection between the first digital twin model (101-132, 201) and the second digital twin model (101-132, 201), the first connection representing a relationship between the first digital twin model (101-132, 201) and the second digital twin model (101-132, 201) at a specified point in time. The example apparatus includes digital twin processing circuitry to process the query to identify the first snapshot (600) and the second snapshot (600), determine a correlation, and generate a result with an actionable output.

## Description

### FIELD

The present disclosure relates to systems and methods for digital twin modeling and analysis, and more specifically, for digital twin management and query.

### BACKGROUND

An aircraft is a complicated machine with many parts and many opportunities for an error or failure. As such, monitoring and prediction of failure is important to drive preventative maintenance for the health of the aircraft, its passengers and crew, as well as cargo. However, an ability to monitor and predict in such a complicated system is currently limited. As a result, errors can occur.

### BRIEF DESCRIPTION OF THE DRAWINGS

A full and enabling disclosure of the present technology, including the best mode thereof, directed to one of ordinary skill in the art, is set forth in the specification, which makes reference to the appended figures, in which:
FIG. 1 shows an example network of aircraft digital twin models.
FIG. 2 shows an example implementation of an example engine model of the example aircraft model of FIG. 1.
FIG. 3 illustrates a model and snapshot management system.
FIG. 4 illustrates an example implementation of the example memory circuitry of FIG. 3.
FIG. 5 shows an example implementation of the example processing circuitry of FIG. 3.
FIG. 6 illustrates an example hierarchy or set of layers/levels forming a model graph snapshot.
FIG. 7 illustrates another example representation of a tiered set of digital twins combining to describe an aircraft.
FIG. 8A depicts an example database organization in a data storage layer for the example memory circuitry of FIG. 3.
FIG. 8B depicts an example database organization in a data storage layer for the example memory circuitry of FIG. 3.
FIG. 8C depicts an example database organization in a data storage layer for the example memory circuitry of FIG. 3.
FIG. 9 illustrates an example collection or network of digital twin models and associated event processing.
FIG. 10 illustrates one example output in the form of a graphical user interface.
FIG. 11 is a flow diagram representative of example hardware logic, machine readable instructions, hardware implemented state machines, and/or any combination thereof for implementing the example digital twin model management system of FIGS. 1-10.
FIG. 12 is a flow diagram representative of example hardware logic, machine readable instructions, hardware implemented state machines, and/or any combination thereof for implementing the example digital twin model management system of FIGS. 1-10.
FIG. 13 is a block diagram of an example processing platform including processor circuitry structured to execute the example machine readable instructions of FIGS. 11-12 to implement the example digital twin model management system.
FIG. 14 is a block diagram of an example implementation of the processor circuitry of FIG. 13.
FIG. 15 is a block diagram of another example implementation of the processor circuitry of FIG. 13.

The figures are not to scale. Instead, the thickness of the layers or regions may be enlarged in the drawings. In general, the same reference numbers will be used throughout the drawing(s) and accompanying written description to refer to the same or like parts. As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other. Stating that any part is in "contact" with another part means that there is no intermediate part between the two parts.

Descriptors "first," "second," "third," etc. are used herein when identifying multiple elements or components which may be referred to separately. Unless otherwise specified or understood based on their context of use, such descriptors are not intended to impute any meaning of priority, physical order, or arrangement in a list, or ordering in time but are merely used as labels for referring to multiple elements or components separately for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for ease of referencing multiple elements or components.

### DETAILED DESCRIPTION

Assets, such as aircraft, can include a plurality of components, each susceptible to error, failure, update, etc. Such assets can operate together as well as separately, and, sometimes, a component can be moved from one asset to another asset in a fleet. Alternatively or additionally, other changes in configuration, status, operation, performance, etc., occur for each individual asset over time. Tracking and responding to changes in a collection of assets over time poses technical challenges in modeling, relationships, and temporal as well as spatial navigation. Certain examples provide models (e.g., asset object models), such as a physics-based digital "twin", which is a virtual model of an asset, interconnected and/or inter-related over time for improved modeling of assets and relationships physically and over time.

Certain examples provide a framework or hierarchy of models and associated systems and methods for interconnecting and organizing a plurality of models, such as digital twins, other asset object model, etc., to query, analyze, diagnose, and/or adjust based on one or more criterion, question, problem, other issue, etc. For example, the framework can correspond to a fleet or network of aircraft, to a particular aircraft forming part of the fleet, to particular engine(s) on that aircraft, etc. For example, suppose a first engine is paired with a second engine on a first plane, and the second engine is then moved to a second plane. If the first engine experiences an issue, the framework can be used to locate the second engine, which is now on the second plane, and evaluate the second engine for the issue as well. Further, the framework stores snapshots of a network or set of digital twin and/or other data at a variety of points in time to enable querying, replay, modeling, and/or extrapolation, etc., such as to determine what was happening in the model(s) at certain points in time, perhaps versus what is happening in those model(s) today. As such, certain examples provide a device- and time-based interconnected framework.

The framework (e.g., a digital twin network) provides multiple connected models at multiple snapshots in time. Connections between models can be traversed at arbitrary times in the past. In certain examples, relationships are recorded as change events, and asset-centric snapshots capturing these change events can be leveraged for problem solving, repair, preventative maintenance, other prediction, etc.

A digital representation, digital model, digital "twin", or digital "shadow" is a digital informational construct about a physical system. That is, digital information can be implemented as a "twin" of a physical device/system/person and information associated with and/or embedded within the physical device/system. The digital twin is linked with the physical system through the lifecycle of the physical system. In certain examples, the digital twin includes a physical object in real space, a digital twin of that physical object that exists in a virtual space, and information linking the physical object with its digital twin. The digital twin exists in a virtual space corresponding to a real space and includes a link for data flow from real space to virtual space as well as a link for information flow from virtual space to real space and other virtual sub-spaces.

In some examples, sensors connected to the physical object (e.g., an aircraft, an engine, etc.) can collect data and relay the collected data to the digital twin. Interaction between a plurality of digital twins can help improve modeling and prediction to diagnose an issue, order maintenance, improve utilization and/or operation, etc., for example. Rather than a generic model, a digital twin is a collection of actual physics-based and/or mathematically-based models reflecting the system/object and associated characteristic(s), condition, relationship(s), etc. In certain examples, the digital twin can be used for monitoring, diagnostics, prognostics, adjustment, etc. Historical information, relationships, current and/or future information, etc., can be leveraged with the digital twin for predictive maintenance, issue diagnosis/determination, etc.

In contrast to computers, humans do not process information in a sequential, step-by-step process. Instead, people try to conceptualize a problem and understand its context. While a person can review data in reports, tables, etc., the person is most effective when visually reviewing a problem and trying to find its solution. Typically, however, when a person visually processes information, records the information in alphanumeric form, and then tries to re-conceptualize the information visually, information is lost and the problem-solving process is made much less efficient over time.

Using the digital twin, however, allows a person and/or system to view and evaluate a complex system and associated trends, issues, improvements, etc., without translating to data and back. The digital twin can be used in simulation and can also drive comparison (e.g., between aircraft, between aircraft components, between time periods, etc.). The digital twin can be used to model and describe at a macro level (e.g., entire aircraft, entire engine, entire fleet, etc.) and/or at a micro level (e.g., a compressor, a valve, a controller, etc.).

Certain examples provide a framework or architecture including a network of digital twins. The example framework interconnects a plurality of digital twins and enables query, traversal, and interaction with one or more of the interconnected plurality of digital twins. Certain examples provide one or more "snapshots" of a network of digital twin(s) at various points in time. As such, a digital twin for an asset (e.g., an engine, a controller, an airframe, an aircraft, etc.) can be compared over time to identify changes in the characteristics, properties, status, etc., of that digital twin (e.g., how an engine's performance evolved over time, etc.). Additionally, for a given point in time, the state of a plurality of digital twins can be identified and retrieved from the network (e.g., on a date of failure of engine one, what was the status of engine two, based on their respective digital twins), for example. Thus, the highly dynamic nature of assets with changing relationships over time (e.g., engines moving from one plane to another or otherwise being replaced, a controller being installed with an engine, airplanes being deployed together, etc.) can be modeled, captured, and leveraged for comparison, prediction, and/or other processing, for example.

Using asset digital twins, aircraft and/or aircraft components can be modeled, tracked, analyzed, and improved/maintained over their lifecycle. Digital twins can be expressed for individual assets in isolation (e.g., a jet engine, along with its associated properties such as health and status, etc.). A plurality of digital twins can also capture various relationships between multiple assets (e.g., a jet engine is mounted on an airframe, is paired with another engine, etc.) by linking the twins into one or more directed graphs, for example. As such, properties of digital twins as well as relationships between digital twins can be captured, stored, modeled, analyzed, and leveraged over time.

In certain examples, a digital twin is a model of an asset that captures how the asset operates over time. A plurality of digital twins interconnect in accordance with an asset model as a network of digital twins (also referred to herein as a graph of digital twins or a digital twin graph). When a change occurs among the interconnected assets (and associated digital twins), a change event is captured and/or otherwise created and stored in a snapshot. In certain examples, a snapshot is a snapshot of all or part of a network of digital twin models at a particular point of time. The snapshot is stored, and a plurality of snapshots form a record of evolution of the state of the network. For example, a cloud database stores changes to the network of digital twins as a plurality of snapshots over time. Change events signify changes to the network of digital twins.

A history of changes among digital twins can be navigated via snapshots of the network graph of digital twins. For example, change events from the network of digital twins can be captured, modeled, and stored for further query, analysis, and adjustment. The network of digital twins enables asset lifecycle management through a holistic view of the health and status of, and relationships between, assets over time. Digital twins of respective assets can be modeled using a conceptual object modeling methodology such as an ontology, for example (e.g., Digital Twin Definition Language (DTDL), other description/definition language, other modeling methodology, etc.). Actual instances of asset digital twins, their properties, and links between them conforming to asset object models constitute point-in-time digital twin graphs. To enable applications to leverage change event data from digital twin graphs, certain examples provide a three-step process including 1) ingestion of the change event data, 2) persistent storage of the change event data via a cloud-based database service, and 3) querying of change event data via terms defined in an asset object model, for example.

In certain examples, one or more data models for digital twin snapshot graphs are defined for temporally-consistent representation of change event data from digital twin graphs within a cloud-scale multi-model/document database. The data partitioning and indexing strategy for snapshot data in the data model is determined based on an asset object model. Change events are captured and routed via event processing services and transformed into a snapshot data model for ingestion into a database, for example, via functions-as-a-service and/or serverless functions. Application program interfaces (APIs) are provided to support time-based analytics (e.g., point-in-time queries, range queries, etc.). In certain examples, resolvers translate high-level queries into a corresponding series of low-level queries against a database service.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc. may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, and (7) A with B and with C. As used herein in the context of describing structures, components, items, objects and/or things, the phrase "at least one of A and B" is intended to refer to implementations including any of (1) at least one A, (2) at least one B, and (3) at least one A and at least one B. Similarly, as used herein in the context of describing structures, components, items, objects and/or things, the phrase "at least one of A or B" is intended to refer to implementations including any of (1) at least one A, (2) at least one B, and (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, and (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, and (3) at least one A and at least one B.

As used herein, singular references (e.g., "a", "an", "first", "second", etc.) do not exclude a plurality. The term "a" or "an" entity, as used herein, refers to one or more of that entity. The terms "a" (or "an"), "one or more", and "at least one" can be used interchangeably herein. Furthermore, although individually listed, a plurality of means, elements or method actions may be implemented by, e.g., a single unit or processor. Additionally, although individual features may be included in different examples or claims, these may possibly be combined, and the inclusion in different examples or claims does not imply that a combination of features is not feasible and/or advantageous.

As used herein, the terms "system," "unit," "module," "engine," "component," etc., may include a hardware and/or software system that operates to perform one or more functions. For example, a module, unit, or system may include a computer processor, controller, and/or other logic-based device that performs operations based on instructions stored on a tangible and non-transitory computer readable storage medium, such as a computer memory. Alternatively, a module, unit, or system may include a hard-wires device that performs operations based on hardwired logic of the device. Various modules, units, engines, and/or systems shown in the attached figures may represent the hardware that operates based on software or hardwired instructions, the software that directs hardware to perform the operations, or a combination thereof.

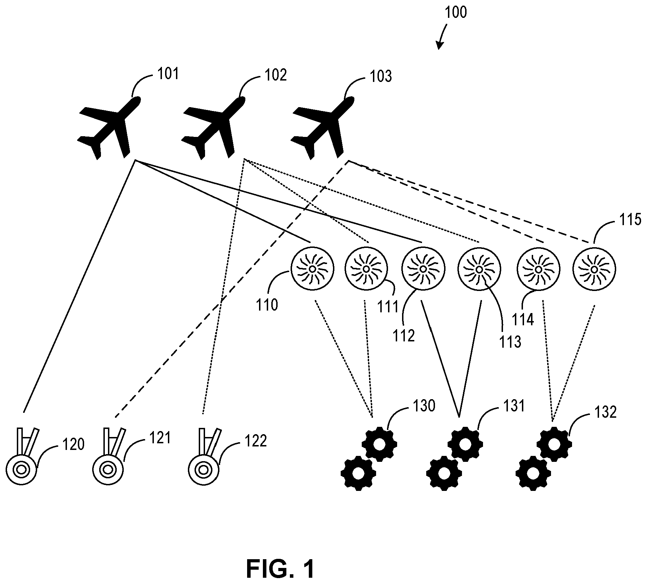

FIG. 1 shows an example network 100 of multiple aircraft represented by aircraft models 101, 102, 103. Each aircraft model 101-103 is associated with one more asset models, such as engine models 110, 112, 113, 114, 115, landing gear models 120, 121, 122, airframe models, etc. Each asset model, such as the engine models 110-115, can be further associated with one or more component models 130, 131, 132, which can be used to represent and evaluate engine 110-115 subsystem(s) such as a compressor, a combustion chamber, a turbine, a controller, etc. Asset relationships change over time as assets are repaired, replaced, reconfigured, etc. The fleet or network 100 of models 101-132 can help to track, correlate, and predict changes when organized as a framework.

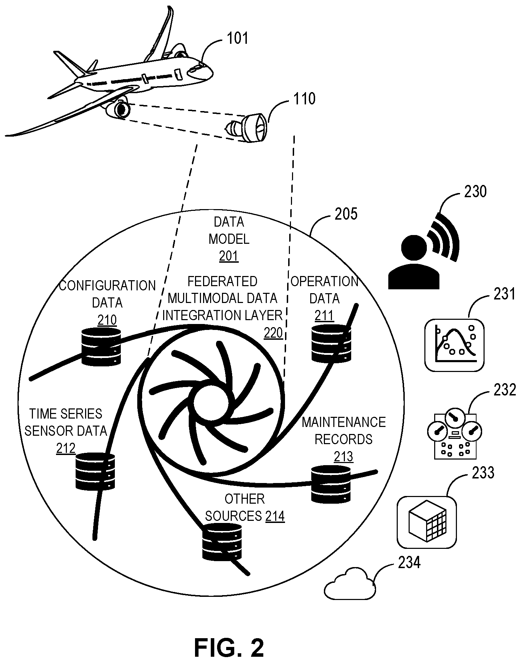

FIG. 2 shows an example implementation of the example engine model 110 of the aircraft model 101 of FIG. 1. In the example of FIG. 2, the digital twin of the engine model 110 is implemented using a digital twin data model 201 with a data security layer 205 regulating access to and from the digital twin data model 201. The example digital twin data model 201 can be composed of a plurality of data structures 210, 211, 212, 213, 214 correlated via a federated, multimodal data integration layer 220. For example, as shown in FIG. 2, the digital twin data model 201 corresponding to engine model 110 is composed of configuration data 210, operational data 211, time series sensor data 212, maintenance records 213, other sources 214, etc. The example digital twin data model 201 for the engine model 110 can be used to enable queries 230, drive analytics 231, generate dashboards 232, provide visualization 233, store remotely 234, etc. The multimodal data integration layer 220 enables the various data structures 210-214 to be leveraged with new information, queries 230, drive analytics 231, etc., to convey information about the associated engine at various points in time.

As such, the engine model 110 can be implemented as a computable hierarchical asset model, which can be queried and explored. The digital twin data model 201 forms a digital record of the physical asset including real-time instance data capturing knowledge regarding components and/or features of the asset. As such, the digital twin data model 201 facilitates traceability of the asset and its components over time, based on location, etc. The digital twin data model 201 enables integration and analysis of data across repositories in a single logical view without requiring a priori physical unification of the data.

While the example of FIG. 2 is illustrated with respect to the engine model 110, the data modeling methodology similar to the one adopted in the example digital twin data model 201 can be used to implement one or more of the asset models 110-132. Using such models, an asset's lifecycle can be monitored and a holistic, actionable view of asset health and status (e.g., past, present, and future) can be provided.

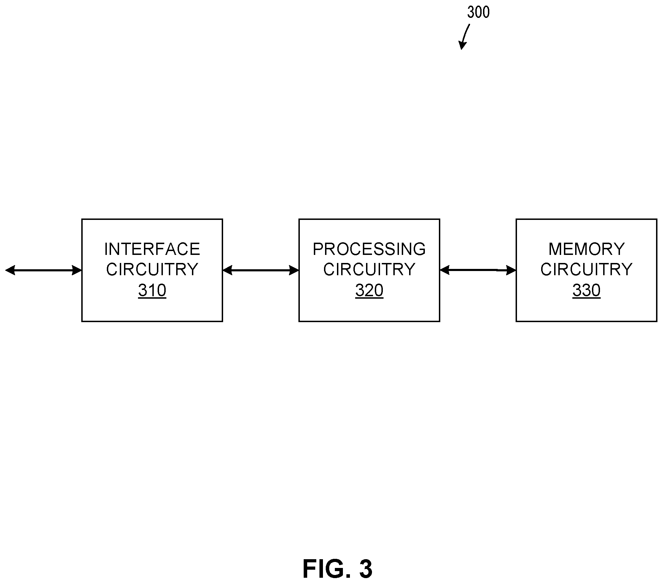

FIG. 3 illustrates a model and snapshot management system 300 for ingestion, update, management, query, and processing of digital twin models for asset health management. The example snapshot management system 300 includes interface circuitry 310, processing circuitry 320, and memory circuitry 330. All or part of the snapshot management system 300 can be cloud-based, edge-based, implemented on one or more servers and data stores, etc.

The example interface circuitry 310 processes information regarding an asset (e.g., an aircraft, an engine, a controller, landing gear, another aircraft component, etc.) to create a new digital twin to be stored in the memory circuitry 330, to update an existing digital twin stored in the memory circuitry 330, to create a snapshot to be stored in the memory circuitry 330, to process a query with respect to one or more snapshots, etc. The example interface circuitry 310 also provides an output from one or more digital twin models, snapshots, etc., in the memory circuitry 330 as driven by the processing circuitry 320.

The example processing circuitry 320 manages asset models or digital twins as well as input of data and/or queries via the interface circuitry 310 in the memory circuitry 330. The processing circuitry 320 tracks changes to an asset's digital twin over time as well as changes to the network of digital twins over time and enables ingestion of change events, storage of snapshots representing these change events, and querying of snapshots and/or models via an application programming interface (API), etc. As such, the processing circuitry 320 creates a new digital twin data model 110-132 based on input data from the interface circuitry 310, for example. The processing circuitry 320 also updates an existing digital twin data model 110-132 stored in the memory circuitry 330 based on input from the interface circuitry 310, for example. Such an update can include a change to the asset model, a change to the digital twin data model associated with the asset, etc. The processing circuitry 320 also facilitates querying of the memory circuitry 330 based on input from the interface circuitry 310 to identify one or more digital twin data models, determine relationships among models, locate a snapshot of a model in time, compare models, etc.

In certain examples, the processing circuitry 320 transforms change events from a network or graph of modeled assets (e.g., a digital twin graph) 100 into snapshots associated with some subset of asset models 110-132. Change events can be provided to the processing circuitry 320 via the interface circuitry 310, for example. For example, a change event can include the addition of a digital twin to the network graph such as from adding an aircraft to a fleet, adding an engine slot to an airframe, attachment of an engine on an airframe, maintenance on an engine, flight of an aircraft, etc. The processing circuitry 320 uses the change event to process the digital twin network (network graph) 100 including associated asset models 110-132 (e.g., the aircraft, airframe, and engine models, etc.) to update the state of the associated model(s) 110-132 based on the change event, for example. The processing circuitry 320 saves the subgraph or network of a subset of asset model(s) 110-132 as a snapshot which reflects the state and content/configuration of the impacted asset model(s) 110-132 at that point in time when the change event occurred. The snapshot(s) are stored by the processing circuitry 320 in the memory circuitry 330.

The memory circuitry 330 stores a plurality of asset models 110-132 organized in an interconnected network (e.g., for a fleet, for an aircraft, for an aircraft sub-system, etc.). The models 110-132 are linked in the memory circuitry 330 (e.g., via a graph such as a connected graph, multigraph, directed graph, etc., and/or other linked/interconnected memory arrangement). The memory circuitry 330 enables the network of models 110-132 to be stored, updated, retrieved, and/or otherwise utilized securely and stably, such as by the processing circuitry 320. The memory circuitry 330 stores the captured snapshots of the models 110-132 interconnected in the network 100 for query, retrieval, and analysis.

In certain examples, snapshots of the subgraph or network connecting models 110-132 can be organized in one or more containers and/or other logical data constructs in one or more databases in the memory circuitry 330. One or more containers can be partitioned for efficient database operation, and to isolate snapshots and/or associated models 110-132 within a container, for example. As such, different snapshots and associated model or asset levels (e.g., operator, airframe, engine slot, engine, etc.) can be associated with different container(s). In certain examples, the set of containers in the memory circuitry 330 can include a property container and a relationship container for each managed asset (e.g., aircraft, engine, etc.) in an asset model. For example, snapshots in a property container include properties (e.g., health, status, etc.) of an asset instance (e.g., engine123, etc.) of an asset type (e.g., engine, etc.) at a given point in time. Snapshots in a relationship container connect a plurality of models of multiple types. For example, a snapshot in an engine relationship container can include links between an engine instance (e.g., engine123) and all other assets to which it is connected at that point in time (e.g., airframe1, controlled, etc.). The memory circuitry 330 can include a lookup container to facilitate organization of snapshots among the other containers in the memory circuitry 330, for example. Snapshots can be routed by the processing circuitry 320 to relevant container(s), for example.

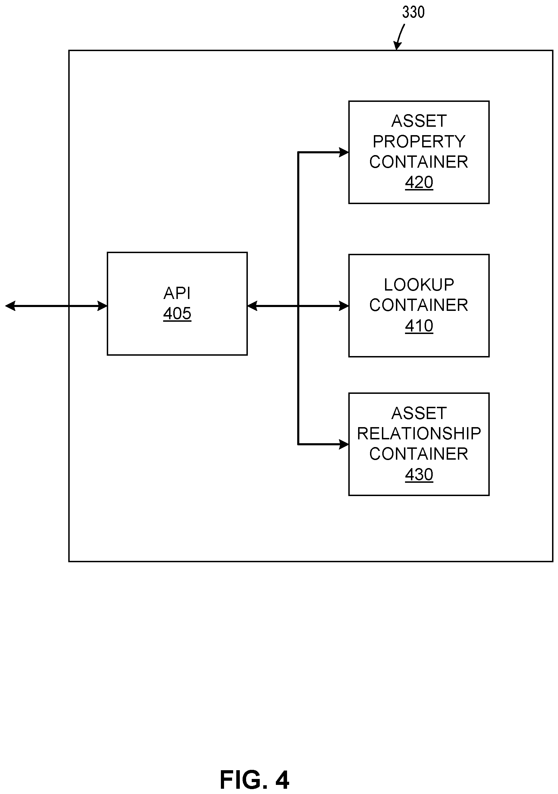

FIG. 4 illustrates an example implementation of the memory circuitry 330 including a plurality of containers. As shown in the example of FIG. 4, containers organizing the memory circuitry 330 can include a lookup container 410, an asset property container 420 for each type of digital twin in an asset model, and an asset relationship container 430 for each type of digital twin in an asset model. As such, snapshots including models 110-132 for an asset, such as an aircraft, fleet of aircraft, aircraft components, etc., and changes to the network of asset models can be organized according to the containers 410-430 of the example of FIG. 4. Changes associated with an engine, a plurality of assets on an aircraft, an aircraft, a fleet of aircraft, etc., can be modeled and stored as an interconnected snapshot captured at a point in time in an asset property container 420 and an asset relationship container 430, for example.

The processing circuitry 320 can access the lookup container 410 with input data related to change events impacting an asset. The lookup container 410 is connected to the asset relationship container 430. The lookup container 410 indexes a change event in a network of digital twins by the asset that is the subject of a relationship being changed, and correlates a relationship change with an asset in the asset relationship container 430. Using the mapping information of the lookup container 410, the processing circuitry 320 can identify connected and/or otherwise related assets via the asset relationship container 430. As such, analysis of an engine can leverage model(s) of the engine including an engine properties model and an engine relationship model, in which organization of the engine relationship model is facilitated via a lookup data structure, for example.

In operation, for example, the interface circuitry 310 receives a query, such as from an aircraft controller (e.g., a full authority digital engine control (FADEC), other electronic engine controller, other aircraft controller, flight management system, aircraft maintenance controller, etc.). The query can be generated in response to a change detected with respect to an asset (e.g., maintenance, adjustment, error or fault, etc., occurring in an aircraft, airframe, engine slot, engine, landing gear, controller, sensor, etc.). The interface circuitry 310 provides the query to the processing circuitry 320, which parses the query and interrogates the memory circuitry 330 to access a relevant snapshot (e.g., via the asset property container 420 for the engine and/or other relationship container(s) 430 for the engine). Access can be facilitated via an application programming interface (API) 405, for example. For example, an API to access an asset property container or relationship container utilizes a container name (e.g., engine_relationship, etc.), an asset identifier (e.g., engine 123, etc.), and a point in time (e.g., 01/01/2020, etc.) to query the container for an associated snapshot involving the asset. In certain examples, instead of a point in time, the API can accept a time range (e.g., a start time and an end time, etc.) for retrieval of multiple snapshots. For a lookup container, the API for access can include a relationship identifier (e.g., engine1_controller2, etc.), for example. The processing circuitry 320 processes the snapshot including properties of the engine models 110-115 in the snapshot and relationships between models 110-132 stored in the memory circuitry 330 (and/or accessible in another memory structure via the interface circuitry 310).

The processing circuitry 320 traces relationships between asset digital twins having similar properties. For example, a first engine represented by the engine model 110 can be paired with a second engine represented by the engine model 111 on a first aircraft represented by the aircraft model 101. The first engine is then moved to a second aircraft (represented by the aircraft model 102) and paired with a third engine (represented by the engine model 112). If the first engine has an issue (e.g., a failure, suboptimal execution (such as running hot, excessive fuel consumption, etc.), etc.), the processing circuitry 320 can be alerted via the interface circuitry 310 and can access the memory circuitry 330 to query and trace relationships with the first engine model 110. The second engine can be identified via the first engine model 110 and a snapshot associated with a point in time at which the first engine was associated with the first aircraft, and a second snapshot from that same point in time that associated the first aircraft with the second engine. The second engine and its model 111 can then be evaluated by analyzing its properties at that point in time to determine whether corrective and/or preventive action should be taken on the second engine as well as the first engine to the address the issue experienced by the first engine, for example.

For example, a high operating temperature (e.g., above a desired temperature threshold) experienced in the first engine can also be evaluated in the second engine. Similarly, an unexpected fuel consumption (e.g., greater than an expected, reference, or average fuel consumption) by the first engine can be evaluated in the second engine to identify the same or similar issue. Alternatively (or additionally), an analysis of models 110-132 in the snapshot can reveal opposite behaviors in the assets. For example, the first engine may be running at a higher temperature, and an analysis of the second engine model 111 may reveal that the second engine was operating inefficiently, requiring the first engine to bear more load at the flight stage of the snapshot. As such, the snapshot of models 110-132 can enable analysis and correlation between assets leading to improved identification of problems as well as solutions affecting multiple, inter-related components, for example.

As another example, snapshots captured at different points in time can be compared to identify changes (and/or lack thereof) in the state of the associated digital models 110-132 at the respective times associated with the snapshots. As such, an issue identified in an asset (e.g., overheating, imbalance, fuel inefficiency, abnormal airflow, inoperability, etc.) can be evaluated by retrieving and processing a current snapshot and one or more prior snapshots to determine when the issue appeared in the asset, as evidenced by similar occurrence in one or more prior snapshots. At first occurrence of the issue and/or in a snapshot prior to the first occurrence, a state of the asset and/or other components can be evaluated via the models 110-132 to try and determine a cause, symptom, related asset issue, etc. Such analysis can be used to correct the issue, identify likelihood of future occurrence of the issue, predict the issue in a related asset of the snapshot(s), etc.

In certain examples, snapshots can be compared at a same point in time. For example, a first snapshot of a first set of digital twin models 110-132 at time t1 can be compared with a second snapshot of a second set of digital twin models 110-132 where an intersection between the first set and second set is non-empty (e.g., there is overlaps in the digital models 110-132 between the sets).

As such, a network of models 110-132 in the memory circuitry 330 provides an interconnected network of digital twin and/or other models at multiple snapshots in time. The processing circuitry 320 can traverse connections between models 110-132 at a plurality of stored times in the past (e. g., snapshots). Relationship change events, recorded as asset-centric snapshots, can be leveraged for problem solving, repair, preventative maintenance, other prediction, etc. Change events are stored with respect to associated model(s) 110-132 as snapshots, and queries from the processing circuitry 320 can dynamically hop between models 110-132 and associated snapshots to determine causation, predict an outcome, prescribe maintenance and/or other adjustment, manage asset lifecycle and associated usage/repair/replacement, etc. Life-limited parts, long-term usage parts, etc., can be modeled, monitored, and managed via the framework of models 110-132 in the memory circuitry 330 and associated analysis (e.g., retrospective, predictive, etc.) by the processing circuitry 320, for example.

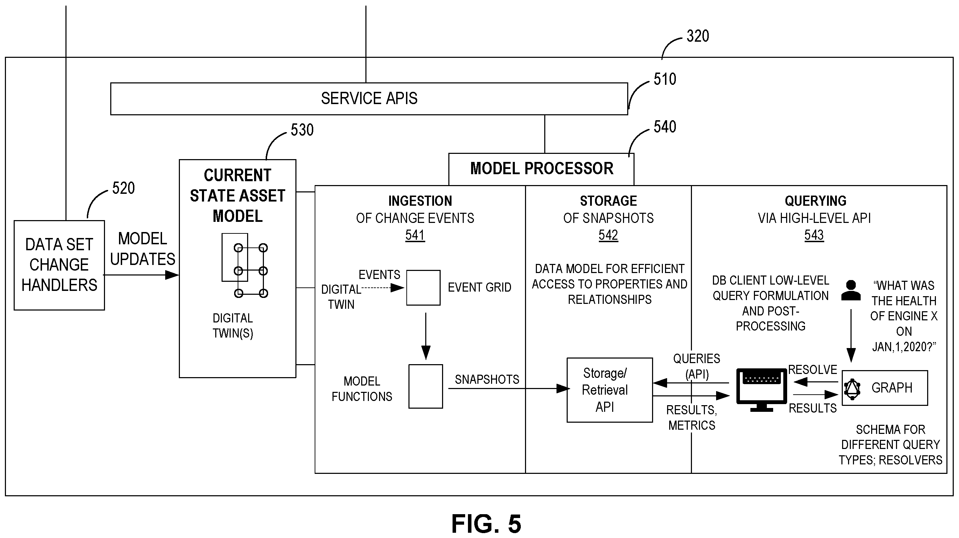

FIG. 5 shows an example implementation of the processing circuitry 320. In the example of FIG. 5, one or more service APIs 510 enable access to the processing circuitry 320 via the interface circuitry 310. The example processing circuitry 320 also includes one or more data set change handlers 520 to update and/or create one or more digital twin models 110-132 in the memory circuitry 330. In the example of FIG. 5, a current state asset model 530 includes one or more digital twins and receives model update(s) (e.g., via the change handler(s) 520). The service API(s) 510 and the current state asset model 530 interact with a model processor 540 to process and adjust information.

For example, as shown in FIG. 5, the model processor 540 can be configured to include and facilitate ingestion of change events 541, storage of snapshots 542, and querying via high-level API 543. As shown in the example of FIG. 5, the processing circuitry 320 handles ingestion of change events 541 by extracting one or more change events from one or more digital twins into an event grid and processing the event(s) in the event grid to form one or more snapshots related to a subset of the current state asset model 530.

The generated snapshot(s) are then stored 542 according to a snapshot data model via snapshot storage service APIs in a database by the memory circuitry 330. The snapshot data model is arranged for efficient access to properties and relationships as described above. The model processor 540 then supports querying 543, via an API, of model(s) 110-132 stored in the memory circuitry 330. For example, a query for the health of engine X on a certain date can be used to interrogate the model(s) 110-132 such as using an API-based GraphQL query, etc. Different query types can be resolved according to different schema, and one or more resolvers of the querying 543 can return results, metrics, etc., from the storage service 542.

As such, the model processor 540 can perform queries based on asset model and time (e.g., temporal model queries). Resolvers can translate a high-level query into one or more low-level queries based on associated data model(s). An API can facilitate queries of the memory circuitry 330 and post-processing results to drive actionable outcomes (e.g., triggering repair and/or other maintenance of an asset (such as scheduling maintenance, pulling an aircraft offline or otherwise shutting down or disabling an asset for maintenance, etc.), monitoring of an asset, reconfiguration of an asset (such as adjustment of a setting or parameter for the asset, etc.), correlation between assets, generating an alarm/alert/warning, triggering modeling of an issue from a first asset in a second asset of the same type or a second asset connected to the first asset, etc.).

As shown in the example implementation of FIG. 5, the processing circuitry 320 can generate and/or update digital twin model(s) for storage in the memory circuitry 330, create snapshot(s) for the network of model(s), query the model(s) for information to drive prediction, determination, adjustment, maintenance, simulation, replay, extrapolation, etc. Changes in asset properties, asset relationships, etc., can be captured as change events and provided to the processing circuitry 320. A change event can drive creation of a digital twin model, update of a digital twin model, creation of a relationship between models, update of a relationship between models, etc. When a relationship change event is introduced into the processing circuitry 320, associated snapshot(s) is/are created from the event and associated with asset model(s) 110-132. Different types of change events can be interpreted in different ways and transformed into snapshot(s) and/or model(s) in different ways. While a change event lacks context, transforming the change event into one or more snapshots in conjunction with asset model(s) 110-132 and other information provides context to one or more change event(s) (e.g., due to model properties, relationships, other information regarding the asset(s), etc.).

The snapshot(s) are routed via 542 snapshot storage service APIs to the memory circuitry 330 for storage according to their associated model(s) 110-132 (e.g., in appropriate asset relationship containers 430 corresponding to their models, etc.). The processing circuitry 320 can later translate a high-level query for asset status into a low-level query of relevant container(s) in the memory circuitry 330, for example, which includes model(s) and information to answer the query. Low-level queries of the data structures in the memory circuitry 330 can be resolved quickly and at low computational cost.

For example, when a new engine slot is being added on a particular airframe at a given timestamp, the processing circuitry 320 identifies two digital twin models involved: an airframe model and an engine slot model. The model processor 540 creates a snapshot of the network including the engine slot digital twin model and the airframe digital twin model at that given timestamp. For example, the model processor 540 determines that, at timestamp 1, airframe0 has an engine slot0, and engine0 is mounted on engine slot0. At timestamp 2, engine0 is still mounted on engine slot0. At timestamp 3, airframe0 adds an engine slot1. A snapshot can enable analysis of events and information from the perspective of different assets (e.g., from the perspective of the engine slot, the airframe, the aircraft, etc.) as well as the relationship of those assets. Changes to one snapshot or model are propagated to other related model(s)/snapshot(s). However, a change affecting one may not affect another. As such, snapshots created at the same timestamp can be queried to evaluate what is occurring/has occurred in multiple, related digital twin models. The processing circuitry 320 maintains consistency across snapshots for different models 110-132 at a given timestamp so that correlation can occur when a query is made, for example.

For example, the collection of snapshots can be queried in response to a blade out event occurring in the engine0 mounted on engine slot0. A prior snapshot can be retrieved in response to the query and analyzed to determine event(s), cause(s), etc., leading up to the blade out event, such as an increase in temperature, etc. An instability in the engine slot0 or an imbalance caused by the addition of engine slot1 may be identified in snapshots prior to the blade out event of engine0. Such events, occurrences, etc., can be provided, analyzed, and used to determine a cause of a change in the engine0 leading to rubbing of the blade against the case, etc., resulting, at a later snapshot in time, in a blade out event. The collection or set of snapshots relating the models 110-132 at different points in time can be queried and analyzed accordingly.

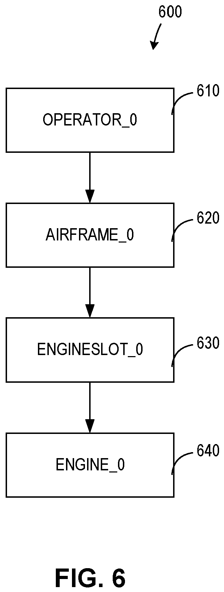

The example model processor 540 translates relationship change events into snapshots, which are generated as partial graphs representing a state of a set of digital twin models 110-132 at a certain timestamp. A snapshot graph can relate one or more digital twin models 110-132, for example. A graph and associated asset model(s) can be layered or divided into levels such as operator, airframe, engine slot, engine, etc. For example, an operator level shows one or more associated airframes; an airframe level shows one or more engine slots; and an engine slot level shows one or more associated engines, etc. FIG. 6 illustrates an example hierarchy or set of layers/levels 610-640 forming a model graph snapshot 600 of an operator 610, an airframe 620, an engine slot 630, and an engine 640.

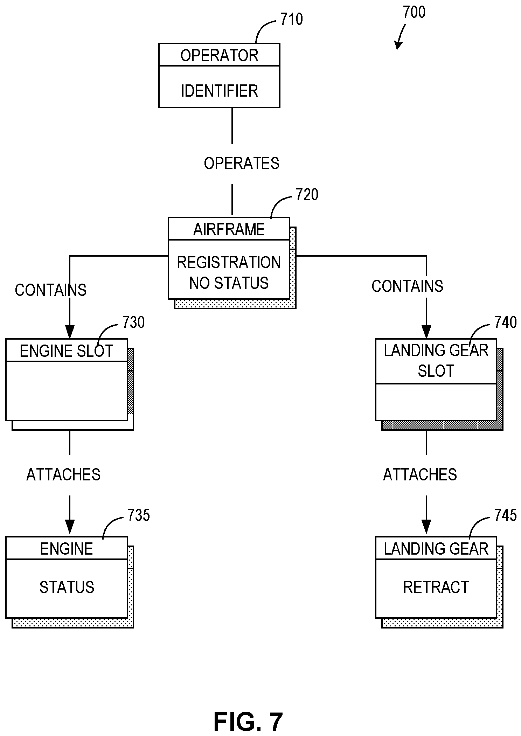

FIG. 7 illustrates another example representation of a tiered set 700 of digital twins 710-740 combining to describe an aircraft. As set forth in the example of FIG. 7, an operator 710 can be represented by an identifier and be associated with (e.g., operate) one or more airframes 720. The one or more airframe models 720 contain asset models, such as one or more engine slot models 730 and one or more landing gear slot models 740. The one or more engine slot models 730 have an attached engine model 735. Each of the one or more engine models 735 provides an associated status of the engine. Similarly, the one or more landing gear slot models 740 have an attached landing gear model 745. Each of the one or more landing gear models 745 provides an associated status of the landing gear (e.g., extended, retracted, error, etc.).

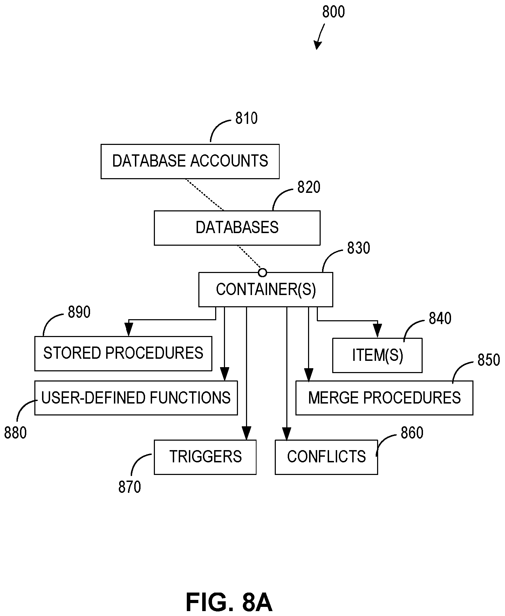

FIGS. 8A-C depict an example database organization in a data storage layer 800 for the memory circuitry 330. The example data storage layer 800 implements a highly-available, globally scalable, multi-model database platform. In certain examples, the data storage layer 800 is rate-limited at specific points, with restriction on throughput at the database and/or container level. As such, partitioning strategy and methodology for storing snapshot data in containers is important to reduce or minimize containers searched and partitions scanned in response to a query.

FIG. 8A shows an example organization or hierarchy of the data storage layer 800 including database accounts 810. Within each database account 810, one or more databases 820 can be organized to store model 110-132, snapshot data, and/or other information, data structure, functions, etc. Each database 820 includes one or more containers 830. The container 830 includes item(s) 840, merge procedures 850, conflicts 860, triggers 870, user-defined functions 880, and stored procedures 890 to facilitate storage, update, query, and actionable outcome in conjunction with the processing circuitry 320.

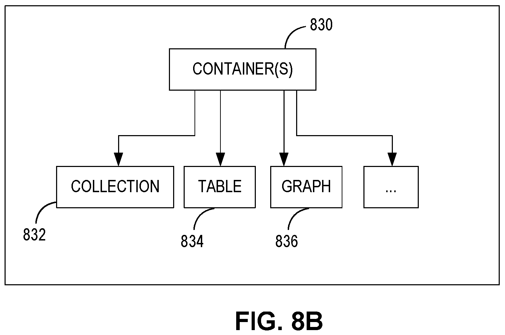

FIG. 8B provides a more detailed view of an example implementation of the container(s) 830. As shown in the example of FIG. 8B, the container 830 in a multi-model database 820 can be configured to store information structured as collections 832, tables 834, or graphs 836, for example. The container(s) 830 can be partitioned and/or otherwise organized to store asset model and associated information, such as relationships, properties, etc. Model and snapshot data can be organized for easy query, retrieval, and modification via one or more of the table 834, graph 836, etc.

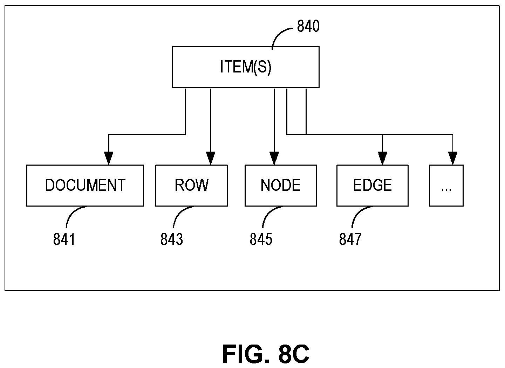

FIG. 8C is a more detailed view of an example implementation of the item(s) 840. As shown in the example of FIG. 8C, an item 840 of the container 830 can be organized as a document 841, a row 843, a node 845, an edge 847, etc. As such, the item 840 enables elements of the container 830 to be easily searchable. The document 841 identifies content of the item 840 in the collection 832. The row 843 specifies a location in the table 834. The node 845 and the edge 847 identify a location in the graph 836, for example. In certain examples, a data storage layer can be implemented for a snapshot data model based on a collection of items (documents), as shown in the example of FIG. 8C. However, the data storage layer can be organized to represent a snapshot data model in other ways.

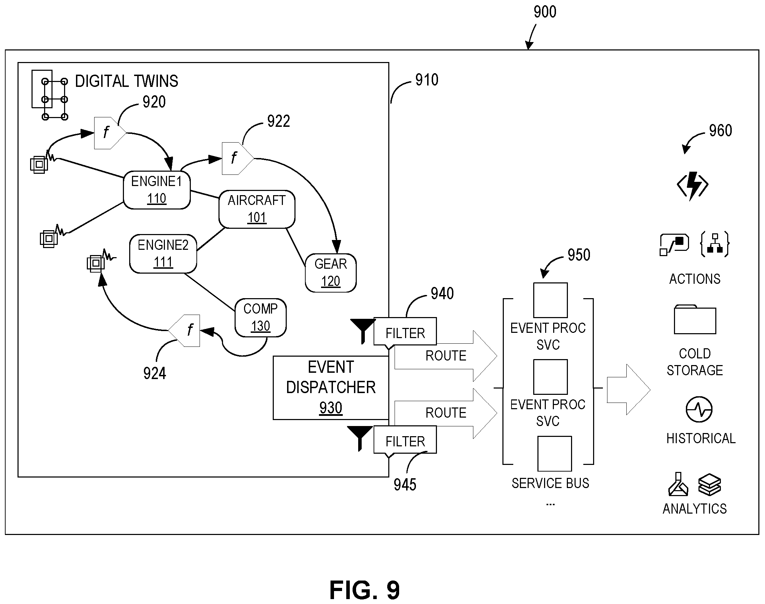

FIG. 9 illustrates an example collection or network 900 of digital twin models 101-130 (e.g., aircraft model 101, engine model 110, engine model 112, gear model 120, component model 130, etc.) and associated event processing. As shown in the example of FIG. 9, a plurality of digital twin models 101-130 and associated functions 920, 922, 924 are interconnected. The functions 920-924 can include processing for telemetry messages, lifecycle notifications, property change notifications, edge change notifications, model change notifications, query processing, etc., and can impact one or more connected models 101-130. In the example of FIG. 9, the aircraft digital twin model 101 is connected to the engine digital twin model 110 and the engine digital twin model 111. The aircraft digital twin model 101 is also connected to the landing gear digital twin model 120. The engine digital twin model 111 is connected to the compressor digital twin model 130. An event dispatcher 930 responds to incoming events and applies one or more filters 940, 945 to route event and/or model data and/or other content to one or more event handlers 950, such as one or more event processing services, a service bus, etc. Event-related content is then processed 960 to generate actions such as actionable output, storage, historical comparison, analytics, time series insights, etc. Example processing functions 960 can interpret different event types: create asset events, change asset property, create relationship, transform event(s) into property and/or relationship snapshot(s), etc.

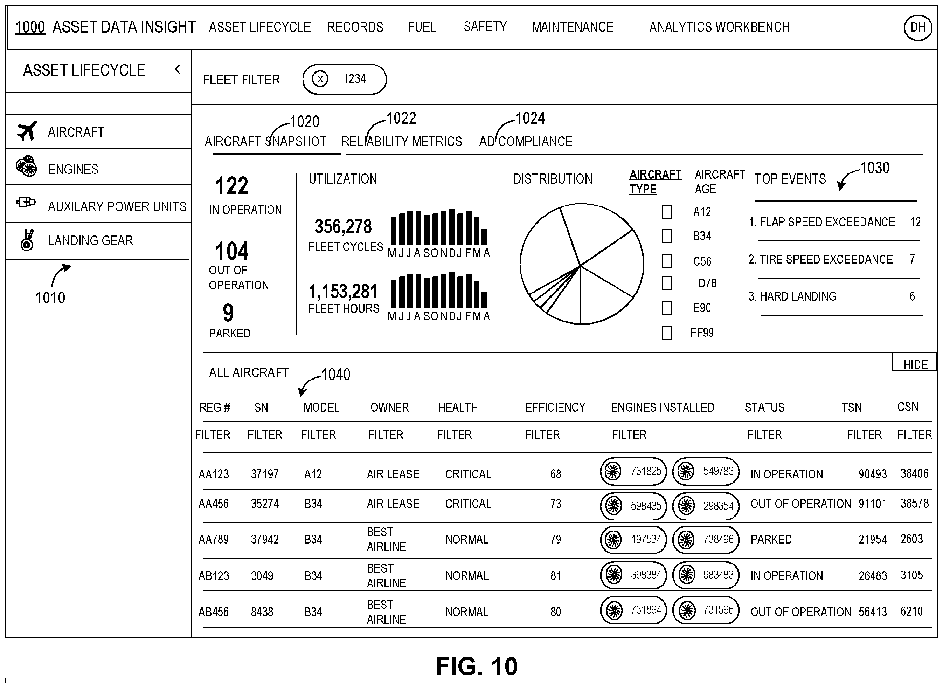

FIG. 10 illustrates one example output in the form of a graphical user interface 1000. Via the example interface or dashboard 1000, a plurality of assets 1010 can be visualized and monitored. The graphical user interface (GUI) 1000 can be driven by the example interface circuitry 310 to display information, provide information in response to user selection, generate change events, trigger corrective action, display instructions, provide instructions, etc. The example GUI 1000 can include an aircraft snapshot 1020, reliability metrics 1022, asset data (AD) compliance 1024, etc. Events 1030 generated with respect to the aircraft can be displayed via the GUI 1000. Information 1040 pulled from models 101-132 of the aircraft can also be displayed via the GUI 1000. The Analytics Workbench can be used to trigger various forms of queries to the digital twin model management system, including those that retrospectively analyze changes to the states of connected digital twin models over time.

While example implementations of the digital twin model management system 300, processing circuitry 320, network of models 900, graphical user interface 1000, etc., are illustrated in FIGS. 1-10, one or more of the elements, processes and/or devices may be combined, divided, re-arranged, omitted, eliminated and/or implemented in any other way. Further, one or more of the elements of FIGS. 1-10 may be implemented by hardware, software, firmware and/or any combination of hardware, software and/or firmware. Thus, for example, any of the example elements of FIGS. 1-10 can be implemented by one or more analog or digital circuit(s), logic circuits, programmable processor(s), programmable controller(s), graphics processing unit(s) (GPU(s)), video processing unit(s) (VPU(s)), accelerator card(s), digital signal processor(s) (DSP(s)), application specific integrated circuit(s) (ASIC(s)), programmable logic device(s) (PLD(s)), trusted platform module(s) (TPM(s)), field programmable gate array(s) (FPGA(s)), and/or field programmable logic device(s) (FPLD(s)). When reading any of the apparatus or system claims of this patent to cover a purely software and/or firmware implementation, at least one of the example elements of FIGS. 1-10 is/are hereby expressly defined to include a non-transitory computer readable storage device or storage disk such as a memory, a digital versatile disk (DVD), a compact disk (CD), a Blu-ray disk, etc. including the software and/or firmware. Further still, the elements of FIGS. 1-10 may include one or more elements, processes and/or devices in addition to, or instead of, those illustrated in FIGS. 1-10, and/or may include more than one of any or all of the illustrated elements, processes, and devices. As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

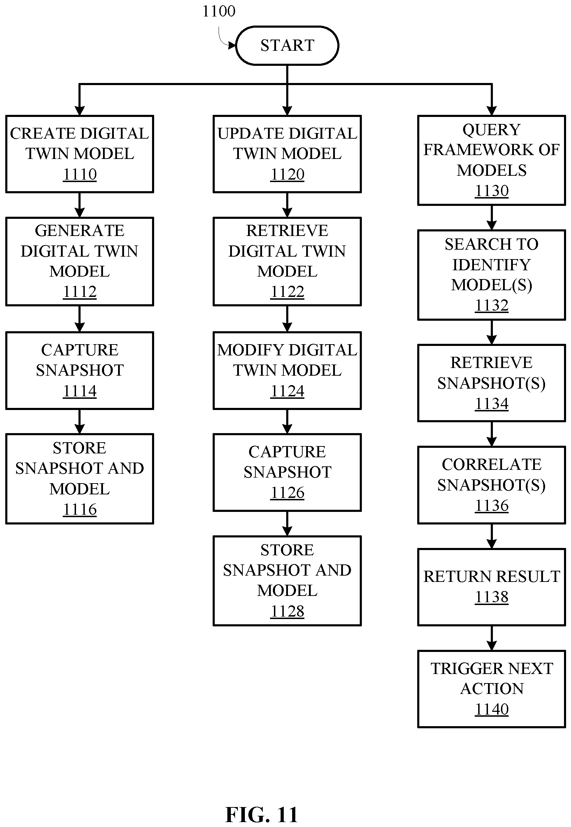

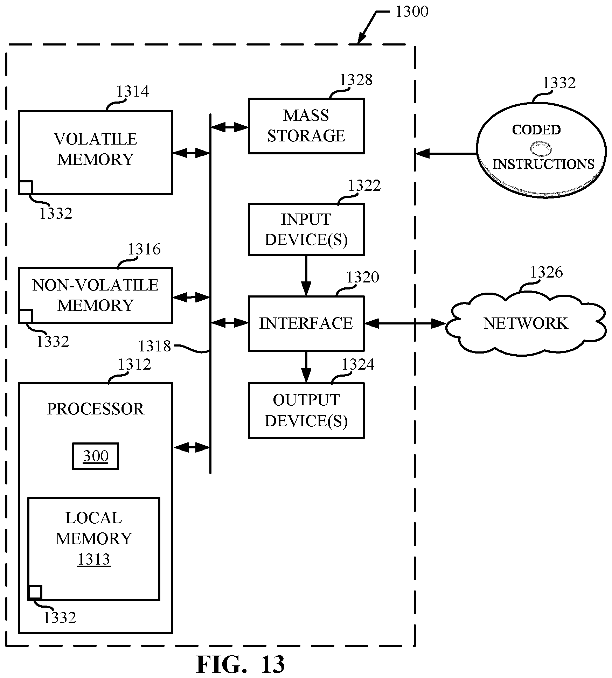

Flowcharts representative of example hardware logic, machine readable instructions, hardware implemented state machines, and/or any combination thereof for implementing the example snapshot management system 300 and/or its components are shown in FIGS. 11-12. The machine readable instructions may be one or more executable programs or portion(s) of an executable program for execution by a computer processor and/or processor circuitry, such as the example snapshot management system 300 and/or the example processor platform 1300 discussed below in connection with FIG. 13. The program may be embodied in software stored on a non-transitory computer readable storage medium such as a CD-ROM, a floppy disk, a hard drive, a DVD, a Blu-ray disk, or a memory associated with the processor 1312, but the entire program and/or parts thereof could alternatively be executed by a device other than the processor 1312 and/or embodied in firmware or dedicated hardware. Further, although the example program is described with reference to the flowcharts illustrated in FIGS. 11-12, many other methods of implementing the example snapshot management system 300 may alternatively be used. For example, the order of execution of the blocks may be changed, and/or some of the blocks described may be changed, eliminated, or combined. Additionally or alternatively, any or all of the blocks may be implemented by one or more hardware circuits (e.g., discrete and/or integrated analog and/or digital circuitry, an FPGA, an ASIC, a comparator, an operational-amplifier (op-amp), a logic circuit, etc.) structured to perform the corresponding operation without executing software or firmware. The processor circuitry may be distributed in different network locations and/or local to one or more devices (e.g., a multi-core processor in a single machine, multiple processors distributed across a server rack, etc.).

The machine readable instructions described herein may be stored in one or more of a compressed format, an encrypted format, a fragmented format, a compiled format, an executable format, a packaged format, etc. Machine readable instructions as described herein may be stored as data or a data structure (e.g., portions of instructions, code, representations of code, etc.) that may be utilized to create, manufacture, and/or produce machine executable instructions. For example, the machine readable instructions may be fragmented and stored on one or more storage devices and/or computing devices (e.g., servers) located at the same or different locations of a network or collection of networks (e.g., in the cloud, in edge devices, etc.). The machine readable instructions may require one or more of installation, modification, adaptation, updating, combining, supplementing, configuring, decryption, decompression, unpacking, distribution, reassignment, compilation, etc. in order to make them directly readable, interpretable, and/or executable by a computing device and/or other machine. For example, the machine readable instructions may be stored in multiple parts, which are individually compressed, encrypted, and stored on separate computing devices, wherein the parts when decrypted, decompressed, and combined form a set of executable instructions that implement one or more functions that may together form a program such as that described herein.

In another example, the machine readable instructions may be stored in a state in which they may be read by processor circuitry, but require addition of a library (e.g., a dynamic link library (DLL)), a software development kit (SDK), an application programming interface (API), etc. in order to execute the instructions on a particular computing device or other device. In another example, the machine readable instructions may need to be configured (e.g., settings stored, data input, network addresses recorded, etc.) before the machine readable instructions and/or the corresponding program(s) can be executed in whole or in part. Thus, machine readable media, as used herein, may include machine readable instructions and/or program(s) regardless of the particular format or state of the machine readable instructions and/or program(s) when stored or otherwise at rest or in transit.

The machine readable instructions described herein can be represented by any past, present, or future instruction language, scripting language, programming language, etc. For example, the machine readable instructions may be represented using any of the following languages: C, C++, Java, C#, Perl, Python, JavaScript, HyperText Markup Language (HTML), Structured Query Language (SQL), Swift, etc.

As mentioned above, the example processes of FIGS. 11-12 may be implemented using executable instructions (e.g., computer and/or machine readable instructions) stored on a non-transitory computer and/or machine readable medium such as a hard disk drive, a flash memory, a read-only memory, a compact disk, a digital versatile disk, a cache, a random-access memory and/or any other storage device or storage disk in which information is stored for any duration (e.g., for extended time periods, permanently, for brief instances, for temporarily buffering, and/or for caching of the information). As used herein, the term non-transitory computer readable medium is expressly defined to include any type of computer readable storage device and/or storage disk and to exclude propagating signals and to exclude transmission media.

FIG. 11 is a flow diagram of another example method 1100 to manage a digital twin model framework. The process 1100 varies depending on whether the processing circuitry 320 is to create a new digital twin model, update an existing digital twin model, or query the network or graph of digital twins.

At block 1110, the processing circuitry 320 is to create a new digital twin model 101-132 of an asset. For example, a new engine added to an engine slot of an airframe can be generated as a new model 110-115 of the physical engine structure and its configuration and operation. At block 1112, a new physics-based model construct (e.g., a machine learning neural network, graph, other model, etc.) is generated based on a set of input (e.g., data, setting, simulation, etc.) describing an asset (e.g., an aircraft, airframe, engine, landing gear, controller, etc.) to form the digital twin model 101-132 of the asset. In addition, at or after the time of creation of the new digital twin model, the processing circuitry 320 is to create new connections in the network of digital twin models 101-132 by linking the newly-created digital twin model to other new or existing digital twin models 101-132 in the network. As such, a graph or network of digital twin models 101-132 is created, updated, etc.

At block 1114, a state of a set of the digital twin models 101-132 in the network is captured, and any newly-created relationship(s) for the digital twin models 101-132 in the network is captured as a snapshot. For example, the state of the newly created model 101-132 including operation, configuration, properties, etc., is captured, and the state of a network of models 101-132 interconnected with the newly created model is captured as a snapshot0 at timestamp t0. At block 1116, the snapshot of the network of digital twin models is stored in the memory circuitry 330. For example, the snapshot including digital twin models 101-132 and associated model state(s), relationship(s), etc., can be stored in an asset property container 420 and/or asset relationship container 430 to enable further query, etc.

At block 1120, the processing circuitry 320 is to update an existing digital twin model 101-132. At block 1122, the particular digital twin model 101-132 is retrieved from the memory circuitry 330, and the snapshot(s) associated with the particular digital twin model 101-132 are retrieved via the lookup container 410, etc. At block 1124, the model processor 540 of the processing circuitry 320 updates the state of the digital twin model 101-132 using input (e.g., one or more change events, update data, simulation, etc.).

At block 1126, a state of a network of models associated with the updated digital twin model 101-132 is captured as a snapshot. For example, the state of the updated model 101-132 including operation, configuration, relationships, properties, etc., is captured as a snapshot1 at time1. At block 1128, the updated digital twin model and associated snapshot are stored in the memory circuitry 330. For example, the model state and/or the snapshot can be stored in an asset property container 420 and/or asset relationship container 430 to enable further query, etc. As such, the container(s) 420, 430, etc., store a collection or set of snapshots for query, analysis, etc.

At block 1130, the framework of digital twins 101-132 is queried by the processing circuitry 320. At block 1132, the framework or network of digital twin models 101-132 stored in the memory circuitry 330 (e.g., in one or more containers, etc.) is queried based on an identifier, search term(s), a type, a condition, an asset class, etc. For example, a particular snapshot can be queried for a known set of digital twin models 101-132 (e.g., a snapshot of models related to a particular aircraft at a particular time). A query can request snapshots including digital twin models 101-132 of a certain engine, a certain type of engine, an identified issue, a relationship, etc. At block 1134, once digital twin model(s) 101-132 associated with the query are identified, snapshot(s) associated with the model(s) 101-132 are retrieved. At block 1136, retrieved snapshot(s) are correlated. For example, the model processor 540 of the processing circuitry 320 correlates retrieved snapshot(s) with respect to the query (e.g., snapshots of two digital twin engine models that were on the same airframe at a time in question, etc.). Snapshots can be correlated based on time, relationship, issue, configuration, etc., to provide a set of snapshots having a defined or otherwise identified relationship to support the query (e.g., snapshots of the same aircraft over time, snapshots of different aircraft having the same type of engine, snapshots of different aircraft with the same engine mounted between them at different points in time, etc.).

At block 1138, the processing circuitry 320 analyzes, generates, and outputs a result to the query based on the correlated and processed snapshot(s). For example, in response to a query regarding an error sensor triggered for a first engine at a first point in time, snapshots for the model 110 of the first engine and the model 111 of a second engine identified to be on the same airframe as the first engine are correlated with a model of the airframe and analyzed to determine whether the same issue afflicting the first engine is afflicting or is likely to afflict the second engine. That analytic/predictive output is provided via the interface circuitry 310 (e.g., via the GUI 1000, a warning indicator, instructions, log, etc.).

At block 1140, a next action is triggered by an actionable output. The actionable output can include a trigger of maintenance of an asset, an adjustment of a setting or parameter for the asset, an alert or alarm, a warning, a shutdown or disabling of the asset, a modeling of an issue in a second asset of the same type or a second asset connected to the asset in question, etc. For example, when the second engine is identified as likely to be afflicted with the same problem as the first engine, preventative maintenance can be triggered for the second engine. As another example, a problem diagnosed in one engine of a certain type under certain flight conditions and lifecycle can be extrapolated to other engines in a fleet and can generate a maintenance schedule to adjust the corresponding engines before the problem is likely to endanger operation.

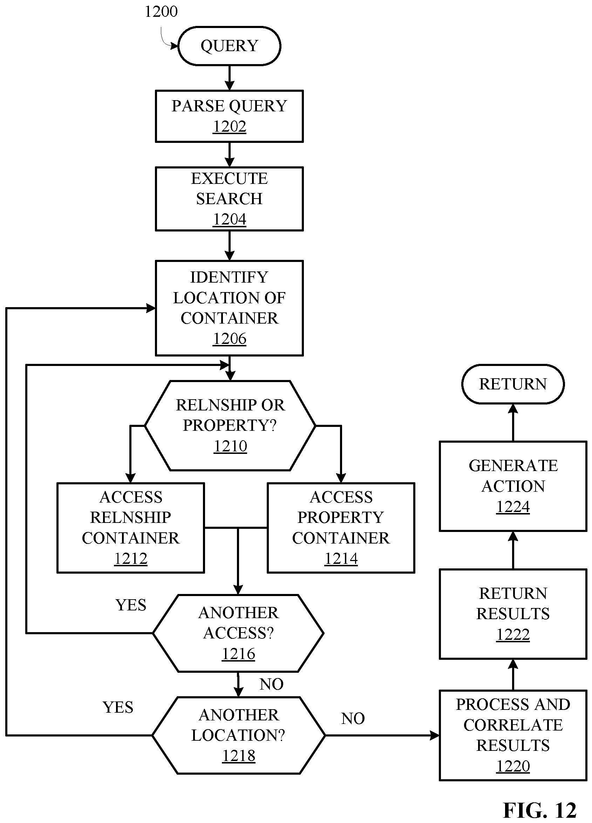

FIG. 12 provides a further example illustration of a query process 1200 of the memory circuitry 330 by the processing circuitry 320 in response to an input via the interface circuitry 310. At block 1202, a query received via the interface circuitry 310 is parsed by the processing circuitry 320. Parsing of the query can identify one or more terms, timing, conditions, constraints, etc., that can form the basis for a search of the memory circuitry 330.

At block 1204, a search is executed based on the parsed query. For example, the processing circuitry 320 interrogates the memory circuitry 330 to identify one or more containers storing digital twin model(s) 101-132, associated snapshot(s), etc. At block 1206, a container is identified in the memory circuitry 330. At block 1210, the search is processed to determine whether a relationship and/or a property is involved in the search. When a relationship of an asset is involved in the search (e.g., a relationship of one engine model to other asset model(s), etc.), then, at block 1212, the asset relationship container 430 is accessed to identify asset(s) related to an asset identified in the search (e.g., another engine, airframe, controller, etc., associated with an engine identified in the search, etc.). When a property of an asset is involved in the search (e.g., temperature, velocity, position, etc.), then, at block 1214, the asset property container 420 is accessed to identify property(-ies) of the asset in question (e.g., cycle time, temperature reading, speed measurement, etc.). At block 1216, the process can repeat if another relationship and/or property is involved in the query.

At block 1218, the search is evaluated to determine whether another container was identified with relevant model(s) 101-132, snapshot(s), etc. If so, then control reverts to block 1206. Otherwise, control advances to block 1220, at which results of the search are processed and correlated to determine an output/outcome. For example, in response to a query regarding an error sensor triggered for a first engine at a first point in time, snapshots for the model 110 of the first engine and the model 111 of a second engine identified to be on the same airframe as the first engine are correlated with a model of the airframe and analyzed to determine whether the same issue afflicting the first engine is afflicting or is likely to afflict the second engine.

At block 1222, results of the query/search are returned via the interface circuitry 310. For example, a corresponding engine, likelihood of failure, fleet status, etc., can be displayed via the GUI 1000, a warning indicator, instructions, log, etc. At block 1224, an action is generated based on the results. For example, when the second engine is identified as likely to be afflicted with the same problem as the first engine, an actionable output triggers preventative maintenance for the second engine. As another example, a problem diagnosed in one engine of a certain type under certain flight conditions and lifecycle can be extrapolated to other engines in a fleet, and the actionable output can generate a maintenance schedule to adjust the corresponding engines before the problem is likely to endanger operation.

FIG. 13 is a block diagram of an example processor platform 1300 structured to execute the instructions of FIGS. 11 and/or 12 to implement the example snapshot management system 300, etc. The processor platform 1300 can be, for example, a server, a personal computer, a workstation, a self-learning machine (e.g., a neural network), a mobile device (e.g., a cell phone, a smart phone, a tablet such as an iPad^{™}), a personal digital assistant (PDA), an Internet appliance, or any other type of computing device.

The processor platform 1300 of the illustrated example includes a processor 1312. The processor 1312 of the illustrated example is hardware. For example, the processor 1312 can be implemented by one or more integrated circuits, logic circuits, microprocessors, GPUs, DSPs, or controllers from any desired family or manufacturer. The hardware processor may be a semiconductor based (e.g., silicon based) device.

The processor 1312 of the illustrated example includes a local memory 1313 (e.g., a cache and/or other memory circuitry). The processor 1312 of the illustrated example is in communication with a main memory/memory circuitry including a volatile memory 1314 and a non-volatile memory 1316 via a bus 1318. The volatile memory 1314 may be implemented by Synchronous Dynamic Random Access Memory (SDRAM), Dynamic Random Access Memory (DRAM), RAMBUS^{®} Dynamic Random Access Memory (RDRAM^{®}) and/or any other type of random access memory device. The non-volatile memory 1316 may be implemented by flash memory and/or any other desired type of memory device/memory circuitry. Access to the main memory 1314, 1316 is controlled by a memory controller.

The processor platform 1300 of the illustrated example also includes an interface circuit 1320. The interface circuit 1320 may be implemented by any type of interface standard, such as an Ethernet interface, a universal serial bus (USB), a Bluetooth^{®} interface, a near field communication (NFC) interface, and/or a PCI express interface.

In the illustrated example, one or more input devices 1322 are connected to the interface circuit 1320. The input device(s) 1322 permit(s) a user to enter data and/or commands into the processor 1312. The input device(s) can be implemented by, for example, an audio sensor, a microphone, a camera (still or video), a keyboard, a button, a mouse, a touchscreen, a track-pad, a trackball, and/or a voice recognition system.

One or more output devices 1324 are also connected to the interface circuit 1320 of the illustrated example. The output devices 1324 can be implemented, for example, by display devices (e.g., a light emitting diode (LED), an organic light emitting diode (OLED), a liquid crystal display (LCD), a cathode ray tube display (CRT), an in-place switching (IPS) display, a touchscreen, etc.), a tactile output device, and/or speaker. The interface circuit 1320 of the illustrated example, thus, typically includes a graphics driver card, a graphics driver chip and/or a graphics driver processor.

The interface circuit 1320 of the illustrated example also includes a communication device such as a transmitter, a receiver, a transceiver, a modem, a residential gateway, a wireless access point, and/or a network interface to facilitate exchange of data with external machines (e.g., computing devices of any kind) via a network 1326. The communication can be via, for example, an Ethernet connection, a digital subscriber line (DSL) connection, a telephone line connection, a coaxial cable system, a satellite system, a line-of-site wireless system, a cellular system, etc.

The processor platform 1300 of the illustrated example also includes one or more mass storage devices 1328 for storing software and/or data. Examples of such mass storage devices 1328 include floppy disk drives, hard drive disks, compact disk drives, Blu-ray disk drives, redundant array of independent disks (RAID) systems, and digital versatile disk (DVD) drives.

The machine executable instructions 1332 of FIGS. 11-12 may be stored in the mass storage device 1328, in the volatile memory 1314, in the non-volatile memory 1316, and/or on a removable non-transitory computer readable storage medium such as a CD or DVD.

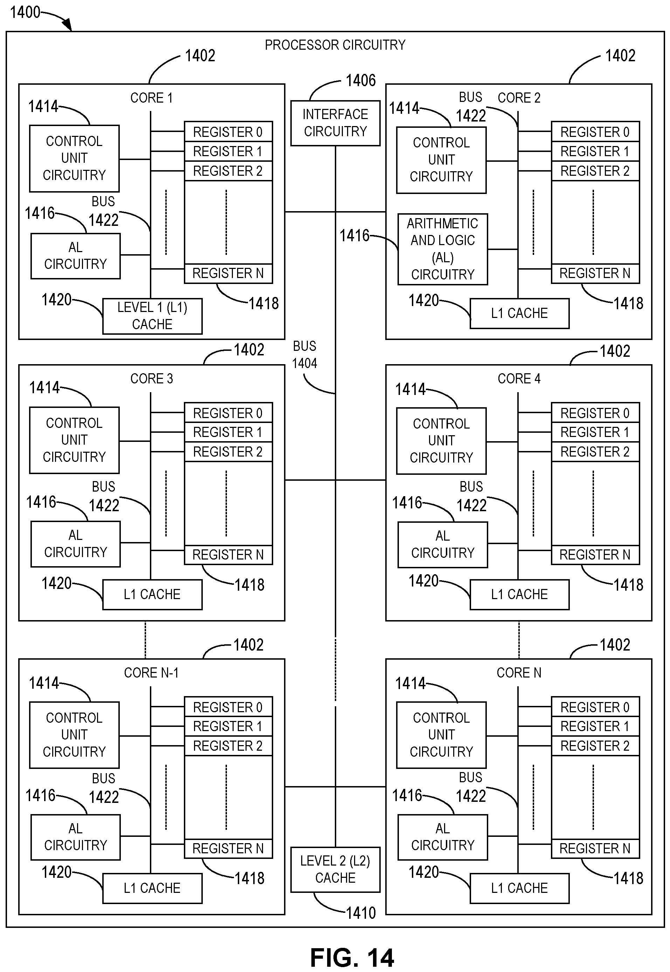

FIG. 14 is a block diagram of an example implementation of the processor circuitry 1312 of FIG. 13. In this example, the processor circuitry 1312 of FIG. 13 is implemented by a microprocessor 1400. For example, the microprocessor 1400 may implement multi-core hardware circuitry such as a CPU, a DSP, a GPU, an XPU, etc. Although it may include any number of example cores 1402 (e.g., 1 core), the microprocessor 1400 of this example is a multi-core semiconductor device including N cores. The cores 1402 of the microprocessor 1400 may operate independently or may cooperate to execute machine readable instructions. For example, machine code corresponding to a firmware program, an embedded software program, or a software program may be executed by one of the cores 1402 or may be executed by multiple ones of the cores 1402 at the same or different times. In some examples, the machine code corresponding to the firmware program, the embedded software program, or the software program is split into threads and executed in parallel by two or more of the cores 1402. The software program may correspond to a portion or all of the machine readable instructions and/or operations represented by the flowcharts of FIGS. 11-12.

The cores 1402 may communicate by an example bus 1404. In some examples, the bus 1404 may implement a communication bus to effectuate communication associated with one(s) of the cores 1402. For example, the bus 1404 may implement at least one of an Inter-Integrated Circuit (I2C) bus, a Serial Peripheral Interface (SPI) bus, a PCI bus, or a PCIe bus. Additionally or alternatively, the bus 1404 may implement any other type of computing or electrical bus. The cores 1402 may obtain data, instructions, and/or signals from one or more external devices by example interface circuitry 1406. The cores 1402 may output data, instructions, and/or signals to the one or more external devices by the interface circuitry 1406. Although the cores 1402 of this example include example local memory 1420 (e.g., Level 1 (L1) cache that may be split into an L1 data cache and an L1 instruction cache), the microprocessor 1400 also includes example shared memory 1410 that may be shared by the cores (e.g., Level 2 (L2_ cache)) for highspeed access to data and/or instructions. Data and/or instructions may be transferred (e.g., shared) by writing to and/or reading from the shared memory 1410. The local memory 1420 of each of the cores 1402 and the shared memory 1410 may be part of a hierarchy of storage devices including multiple levels of cache memory and the main memory (e.g., the main memory 1314, 1316 of FIG. 13). Typically, higher levels of memory in the hierarchy exhibit lower access time and have smaller storage capacity than lower levels of memory. Changes in the various levels of the cache hierarchy are managed (e.g., coordinated) by a cache coherency policy.

Each core 1402 may be referred to as a CPU, DSP, GPU, etc., or any other type of hardware circuitry. Each core 1402 includes control unit circuitry 1414, arithmetic and logic (AL) circuitry (sometimes referred to as an ALU) 1416, a plurality of registers 1418, the L1 cache 1420, and an example bus 1422. Other structures may be present. For example, each core 1402 may include vector unit circuitry, single instruction multiple data (SINM) unit circuitry, load/store unit (LSU) circuitry, branch/jump unit circuitry, floating-point unit (FPU) circuitry, etc. The control unit circuitry 1414 includes semiconductor-based circuits structured to control (e.g., coordinate) data movement within the corresponding core 1402. The AL circuitry 1416 includes semiconductor-based circuits structured to perform one or more mathematic and/or logic operations on the data within the corresponding core 1402. The AL circuitry 1416 of some examples performs integer based operations. In other examples, the AL circuitry 1416 also performs floating point operations. In yet other examples, the AL circuitry 1416 may include first AL circuitry that performs integer based operations and second AL circuitry that performs floating point operations. In some examples, the AL circuitry 1416 may be referred to as an Arithmetic Logic Unit (ALU). The registers 1418 are semiconductor-based structures to store data and/or instructions such as results of one or more of the operations performed by the AL circuitry 1416 of the corresponding core 1402. For example, the registers 1418 may include vector register(s), SIMD register(s), general purpose register(s), flag register(s), segment register(s), machine specific register(s), instruction pointer register(s), control register(s), debug register(s), memory management register(s), machine check register(s), etc. The registers 1418 may be arranged in a bank as shown in FIG. 14. Alternatively, the registers 1418 may be organized in any other arrangement, format, or structure including distributed throughout the core 1402 to shorten access time. The bus 1422 may implement at least one of an I2C bus, a SPI bus, a PCI bus, or a PCIe bus.

Each core 1402 and/or, more generally, the microprocessor 1400 may include additional and/or alternate structures to those shown and described above. For example, one or more clock circuits, one or more power supplies, one or more power gates, one or more cache home agents (CHAs), one or more converged/common mesh stops (CMSs), one or more shifters (e.g., barrel shifter(s)) and/or other circuitry may be present. The microprocessor 1400 is a semiconductor device fabricated to include many transistors interconnected to implement the structures described above in one or more integrated circuits (ICs) contained in one or more packages. The processor circuitry may include and/or cooperate with one or more accelerators. In some examples, accelerators are implemented by logic circuitry to perform certain tasks more quickly and/or efficiently than can be done by a general purpose processor. Examples of accelerators include ASICs and FPGAs such as those discussed herein. A GPU or other programmable device can also be an accelerator. Accelerators may be on-board the processor circuitry, in the same chip package as the processor circuitry and/or in one or more separate packages from the processor circuitry.

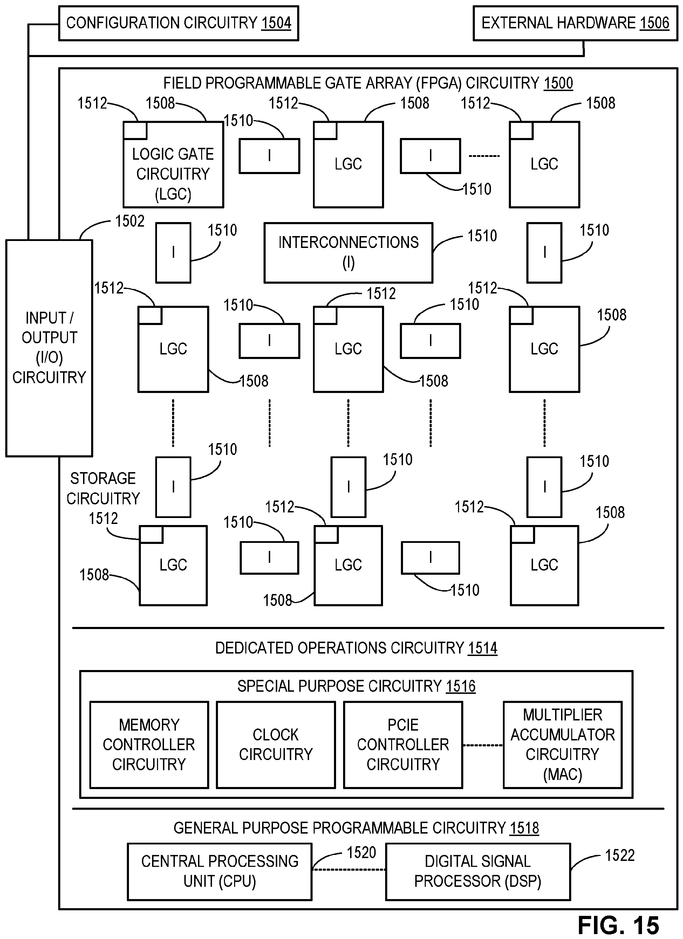

FIG. 15 is a block diagram of another example implementation of the processor circuitry 1312 of FIG. 13. In this example, the processor circuitry 1312 is implemented by FPGA circuitry 1500. The FPGA circuitry 1500 can be used, for example, to perform operations that could otherwise be performed by the example microprocessor 1400 of FIG. 14 executing corresponding machine readable instructions. However, once configured, the FPGA circuitry 1500 instantiates the machine readable instructions in hardware and, thus, can often execute the operations faster than they could be performed by a general purpose microprocessor executing the corresponding software.

More specifically, in contrast to the microprocessor 1400 of FIG. 14 described above (which is a general purpose device that may be programmed to execute some or all of the machine readable instructions represented by the flowcharts of FIGS. 11-12 but whose interconnections and logic circuitry are fixed once fabricated), the FPGA circuitry 1500 of the example of FIG. 15 includes interconnections and logic circuitry that may be configured and/or interconnected in different ways after fabrication to instantiate, for example, some or all of the machine readable instructions represented by the flowcharts of FIGS. 11-12. In particular, the FPGA circuitry 1500 may be thought of as an array of logic gates, interconnections, and switches. The switches can be programmed to change how the logic gates are interconnected by the interconnections, effectively forming one or more dedicated logic circuits (unless and until the FPGA circuitry 1500 is reprogrammed). The configured logic circuits enable the logic gates to cooperate in different ways to perform different operations on data received by input circuitry. Those operations may correspond to some or all of the software represented by the flowcharts of FIGS. 11-12. As such, the FPGA circuitry 1500 may be structured to effectively instantiate some or all of the machine readable instructions of the flowcharts of FIGS. 11-12 as dedicated logic circuits to perform the operations corresponding to those software instructions in a dedicated manner analogous to an ASIC. Therefore, the FPGA circuitry 1500 may perform the operations corresponding to the some or all of the machine readable instructions of FIGS. 11-12 faster than the general purpose microprocessor can execute the same.

In the example of FIG. 15, the FPGA circuitry 1500 is structured to be programmed (and/or reprogrammed one or more times) by an end user by a hardware description language (HDL) such as Verilog. The FPGA circuitry 1500 of FIG. 15, includes example input/output (I/O) circuitry 1502 to obtain and/or output data to/from example configuration circuitry 1504 and/or external hardware (e.g., external hardware circuitry) 1506. For example, the configuration circuitry 1504 may implement interface circuitry that may obtain machine readable instructions to configure the FPGA circuitry 1500, or portion(s) thereof. In some such examples, the configuration circuitry 1504 may obtain the machine readable instructions from a user, a machine (e.g., hardware circuitry (e.g., programmed or dedicated circuitry) that may implement an Artificial Intelligence/Machine Learning (AI/ML) model to generate the instructions), etc. In some examples, the external hardware 1506 may implement the microprocessor 1400 of FIG. 14. The FPGA circuitry 1500 also includes an array of example logic gate circuitry 1508, a plurality of example configurable interconnections 1510, and example storage circuitry 1512. The logic gate circuitry 1508 and interconnections 1510 are configurable to instantiate one or more operations that may correspond to at least some of the machine readable instructions of FIGS. 11-12 and/or other desired operations. The logic gate circuitry 1508 shown in FIG. 15 is fabricated in groups or blocks. Each block includes semiconductor-based electrical structures that may be configured into logic circuits. In some examples, the electrical structures include logic gates (e.g., And gates, Or gates, Nor gates, etc.) that provide basic building blocks for logic circuits. Electrically controllable switches (e.g., transistors) are present within each of the logic gate circuitry 1508 to enable configuration of the electrical structures and/or the logic gates to form circuits to perform desired operations. The logic gate circuitry 1508 may include other electrical structures such as look-up tables (LUTs), registers (e.g., flip-flops or latches), multiplexers, etc.

The interconnections 1510 of the illustrated example are conductive pathways, traces, vias, or the like that may include electrically controllable switches (e.g., transistors) whose state can be changed by programming (e.g., using an HDL instruction language) to activate or deactivate one or more connections between one or more of the logic gate circuitry 1508 to program desired logic circuits.

The storage circuitry 1512 of the illustrated example is structured to store result(s) of the one or more of the operations performed by corresponding logic gates. The storage circuitry 1512 may be implemented by registers or the like. In the illustrated example, the storage circuitry 1512 is distributed amongst the logic gate circuitry 1508 to facilitate access and increase execution speed.

The example FPGA circuitry 1500 of FIG. 15 also includes example Dedicated Operations Circuitry 1514. In this example, the Dedicated Operations Circuitry 1514 includes special purpose circuitry 1516 that may be invoked to implement commonly used functions to avoid the need to program those functions in the field. Examples of such special purpose circuitry 1516 include memory (e.g., DRAM) controller circuitry, PCIe controller circuitry, clock circuitry, transceiver circuitry, memory, and multiplier-accumulator circuitry. Other types of special purpose circuitry may be present. In some examples, the FPGA circuitry 1500 may also include example general purpose programmable circuitry 1518 such as an example CPU 1520 and/or an example DSP 1522. Other general purpose programmable circuitry 1518 may additionally or alternatively be present such as a GPU, an XPU, etc., that can be programmed to perform other operations.

Although FIGS. 14 and 15 illustrate two example implementations of the processor circuitry 1312 of FIG. 13, many other approaches are contemplated. For example, as mentioned above, modern FPGA circuitry may include an on-board CPU, such as one or more of the example CPU 1520 of FIG. 15. Therefore, the processor circuitry 1312 of FIG. 13 may additionally be implemented by combining the example microprocessor 1400 of FIG. 14 and the example FPGA circuitry 1500 of FIG. 15. In some such hybrid examples, a first portion of the machine readable instructions represented by the flowcharts of FIGS. 11-12 may be executed by one or more of the cores 1402 of FIG. 14 and a second portion of the machine readable instructions represented by the flowcharts of FIGS. 11-12 may be executed by the FPGA circuitry 1500 of FIG. 15.

In certain examples, the FPGA circuitry 1500 is leveraged for edge computing. In certain examples, the FPGA circuitry 1500 is implemented in conjunction with the snapshot management system 300 for improved timeliness and/or data fusion. A TPM can also be incorporated to provide and enable hardware and/or software root of trust security for stronger compute/memory/CPU/GPU/etc., at a second/sub-second time constraint.

In certain examples, the processing circuitry 320 implements a means for processing, a means for identifying, and a means for determining. The memory circuitry 330 implements a means for storing, for example. The interface circuitry 310 and the API 405 implement a means for interfacing, for example.

It should now be understood that that the devices, systems, and methods described herein build and maintain a network of digital twins that can be queried to correlate assets, issues, opportunities for maintenance/preventative maintenance, replacement, reconfiguration, etc. The devices, systems, and methods enable fleet management as well as management of assets on an individual aircraft and/or aircraft subsystem. Certain examples generate and correlate a series of snapshots of the network of digital twin models and associated state over time to drive identification and resolution of issues based on relationships, properties, and time. As such, the presently described technology improves digital twin correlation and management. The presently described technology provides new digital twin/snapshot processing circuitry, and the presently described technology improves the structure, organization, and management of memory circuitry.

Example apparatus, systems, and methods to generate, manage, update, and query digital twins are disclosed herein. Further examples and combinations thereof include the following:
Example 1 is an apparatus including interface circuitry to receive input for a query and provide a result of the query as output; memory circuitry to store a plurality of snapshots, each snapshot including a plurality of digital twin models interconnected by a plurality of connections, the plurality of digital twin models including a first digital twin model of a first asset and a second digital twin model of a second asset, the plurality of connections including a first connection between the first digital twin model and the second digital twin model, the first connection representing a relationship between the first digital twin model and the second digital twin model at a specified point in time, each snapshot representing a state of the digital twin models at the point in time, the memory circuitry arranged to enable identification and processing of one or more snapshots in response to the query; and processing circuitry to process the query to search the memory circuitry, the processing circuitry to identify at least a first snapshot and a second snapshot in response to the query, the processing circuitry to determine a correlation between the first snapshot and the second snapshot and generate a result with an actionable output based on the correlation.
Example 2 includes the apparatus of any preceding clause, wherein the first snapshot represents the interconnected plurality of digital twin models at a first point in time and wherein the second snapshot represents the plurality of digital twin models at a second point in time.
Example 3 includes the apparatus of any preceding clause, wherein the correlation includes at least one of i) a change from the first snapshot to the second snapshot over time or ii) a commonality between the first snapshot and the second snapshot.
Example 4 includes the apparatus of any preceding clause, wherein the commonality includes at least one of a related asset on a same airframe or a similar asset on a different airframe.
Example 5 includes the apparatus of any preceding clause, wherein the change includes at least one of i) at least one of the first asset or the second asset moved from a first airframe to a second airframe, ii) a difference between a first configuration of the first asset and the second asset on the first airframe to a second configuration of the first asset and the second asset on the first airframe, or iii) a difference between the first configuration of the first asset and the second asset on the first airframe and a third configuration of the first asset and the second asset on the second airframe.
Example 6 includes the apparatus of any preceding clause, wherein the plurality of digital twin models include at least one of an engine digital twin model, a landing gear digital twin model, a controller digital twin model, an airframe digital twin model, or an aircraft digital twin model.
Example 7 includes the apparatus of any preceding clause, wherein the aircraft digital twin model includes the engine digital twin model, the landing gear digital twin model, the controller digital twin model, and the airframe digital twin model.
Example 8 includes the apparatus of any preceding clause, wherein the aircraft digital twin model is part of a fleet of aircraft digital twin models.
Example 9 includes the apparatus of any preceding clause, wherein the memory circuitry includes a plurality of containers organizing the plurality of digital twin models.
Example 10 includes the apparatus of any preceding clause, wherein the actionable output includes at least one of i) triggering maintenance for at least one of the first asset or the second asset, ii) monitoring at least one of the first asset or the second asset, or iii) reconfiguring at least one of the first asset or the second asset.
Example 11 includes the apparatus of any preceding clause, wherein the processing circuitry is to process a change event to: ingest the change event, store a third snapshot of the plurality of interconnected digital twin models based on the change event, and facilitate querying based on the change event.
Example 12 includes the apparatus of any preceding clause, wherein the processing circuitry includes an application program interface to facilitate ingestion of change events, storage of snapshots, and querying of the memory circuitry.
Example 13 is a non-transitory computer readable storage medium including instructions which, when executed, cause a processor to at least: process a query to search a plurality of snapshots, each snapshot including a plurality of digital twin models interconnected by a plurality of connections, the plurality of digital twin models including a first digital twin model of a first asset and a second digital twin model of a second asset, the plurality of connections including a first connection between the first digital twin model and the second digital twin model, the first connection representing a relationship between the first digital twin model and the second digital twin model at a specified point in time, each snapshot representing a state of the digital twin models at the point in time; identify at least a first snapshot and a second snapshot in response to the query; determine a correlation between the first snapshot and the second snapshot; and generate a result with an actionable output based on the correlation.
Example 14 includes the non-transitory computer readable storage medium of any preceding clause, wherein the first snapshot represents the interconnected plurality of digital twin models at a first point in time and wherein the second snapshot represents the plurality of digital twin models at a second point in time, and wherein the instructions, when executed, cause the processor to correlate the first snapshot and the second snapshot by comparing the first snapshot and the second snapshot to determine at least one of i) a change from the first snapshot to the second snapshot over time or ii) a commonality between the first snapshot and the second snapshot.
Example 15 includes the non-transitory computer readable storage medium of any preceding clause, wherein the instructions, when executed, cause the processor to search a plurality of containers including an asset property container, an asset relationship container, and a lookup container to identify the first snapshot and the second snapshot.
Example 16 includes the non-transitory computer readable storage medium of any preceding clause, wherein the actionable output includes at least one of i) triggering maintenance for at least one of the first asset or the second asset, ii) monitoring at least one of the first asset or the second asset, or iii) reconfiguring at least one of the first asset or the second asset.
Example 17 includes the non-transitory computer readable storage medium of any preceding clause, wherein the instructions, when executed, cause the processor to process a change event to at least one of: ingest a change event, store a snapshot of a first digital twin model of the plurality of digital twin models based on the change event, or facilitate querying based on the change event.
Example 18 is a method including: processing, by executing an instruction using a processor, a query to search a plurality of snapshots, each snapshot including a plurality of digital twin models interconnected by a plurality of connections, the plurality of digital twin models including a first digital twin model of a first asset and a second digital twin model of a second asset, the plurality of connections including a first connection between the first digital twin model and the second digital twin model, the first connection representing a relationship between the first digital twin model and the second digital twin model at a specified point in time, each snapshot representing a state of the digital twin models at the point in time; identifying, by executing an instruction using the processor, at least a first snapshot and a second snapshot in response to the query; determining, by executing an instruction using the processor, a correlation between the first snapshot and the second snapshot; and generating, by executing an instruction using the processor, a result with an actionable output based on the correlation.
Example 19 includes the method of any preceding clause, wherein the first snapshot represents the interconnected plurality of digital twin models at a first point in time and wherein the second snapshot represents the plurality of digital twin models at a second point in time, and wherein the method includes correlating the first snapshot and the second snapshot by comparing the first snapshot and the second snapshot to determine at least one of i) a change from the first snapshot to the second snapshot over time or ii) a commonality between the first snapshot and the second snapshot.
Example 20 includes the method of any preceding clause, wherein processing the query includes processing a change event to at least one of: ingest a change event, store a snapshot of a first digital twin model of the plurality of digital twin models based on the change event, or facilitate querying based on the change event.
Example 21 is a system including: means for processing a query to search a plurality of interconnected digital twin models, the digital twin models associated with snapshots representing a state of the respective digital twin model at a point in time; means for identifying at least a first snapshot and a second snapshot in response to the query; means for determining a correlation between the first snapshot and the second snapshot; and means for generating a result with an actionable output.
Example 22 includes the system of any preceding clause, wherein the first snapshot represents the interconnected plurality of digital twin models at a first point in time and wherein the second snapshot represents the plurality of digital twin models at a second point in time, and wherein the method includes correlating the first snapshot and the second snapshot by comparing the first snapshot and the second snapshot to determine at least one of i) a change from the first snapshot to the second snapshot over time or ii) a commonality between the first snapshot and the second snapshot.
Example 23 includes the system of any preceding clause, wherein the means for processing the query includes means for processing a change event to at least one of: ingest a change event, store a snapshot of a first digital twin model of the plurality of digital twin models based on the change event, or facilitate querying based on the change event.
Example 24 includes the system of any preceding clause, wherein the commonality includes at least one of a related asset on a same airframe or a similar asset on a different airframe.
Example 25 includes the system of any preceding clause, wherein the change includes at least one of i) at least one of the first asset or the second asset moved from a first airframe to a second airframe, ii) a difference between a first configuration of the first asset and the second asset on the first airframe to a second configuration of the first asset and the second asset on the first airframe, or iii) a difference between the first configuration of the first asset and the second asset on the first airframe and a third configuration of the first asset and the second asset on the second airframe.
Example 26 includes the system of any preceding clause, wherein the plurality of digital twin models include at least one of an engine digital twin model, a landing gear digital twin model, a controller digital twin model, an airframe digital twin model, or an aircraft digital twin model.
Example 27 includes the system of any preceding clause, wherein the aircraft digital twin model includes the engine digital twin model, the landing gear digital twin model, the controller digital twin model, and the airframe digital twin model.
Example 28 includes the system of any preceding clause, wherein the aircraft digital twin model is part of a fleet of aircraft digital twin models.
Example 29 includes the system of any preceding clause, wherein means for storing includes a plurality of containers organizing the plurality of digital twin models.
Example 30 includes the system of any preceding clause, wherein the actionable output includes at least one of i) triggering maintenance for at least one of the first asset or the second asset, ii) monitoring at least one of the first asset or the second asset, or iii) reconfiguring at least one of the first asset or the second asset.
Example 31 includes the system of any preceding clause, wherein the processing circuitry includes a means for interfacing to facilitate ingestion of change events, storage of snapshots, and querying of the means for storing.
Example 32 includes the apparatus, method, or system of any preceding clause, wherein the interconnected plurality of digital twin models is a first interconnected plurality of digital twin models, wherein the first snapshot represents the first interconnected plurality of digital twin models at a first point in time, and wherein the second snapshot represents a second plurality of digital twin models at the first point in time.

While particular examples have been illustrated and described herein, it should be understood that various other changes and modifications may be made without departing from the spirit and scope of the claimed subject matter. Moreover, although various aspects of the claimed subject matter have been described herein, such aspects need not be utilized in combination. It is therefore intended that the appended claims cover all such changes and modifications that are within the scope of the claimed subject matter.

The following claims are hereby incorporated into this Detailed Description by this reference. Although certain example systems, methods, apparatus, and articles of manufacture have been disclosed herein, the scope of coverage of this patent is not limited thereto. On the contrary, this patent covers all systems, methods, apparatus, and articles of manufacture fairly falling within the scope of the claims of this patent.

## Claims

1. An apparatus comprising:
interface circuitry (310) to receive input for a query and provide a result of the query as output;
memory circuitry (330) to store a plurality of snapshots (600), each snapshot (600) including a plurality of digital twin models (101-132, 201) interconnected by a plurality of connections, the plurality of digital twin models (101-132, 201) including a first digital twin model (101-132, 201) of a first asset and a second digital twin model (101-132, 201) of a second asset, the plurality of connections including a first connection between the first digital twin model (101-132, 201) and the second digital twin model (101-132, 201), the first connection representing a relationship between the first digital twin model (101-132, 201) and the second digital twin model (101-132, 201) at a specified point in time, each snapshot (600) representing a state of the digital twin models at the point in time, the memory circuitry arranged to enable identification and processing of one or more snapshots (600) in response to the query; and
digital twin processing circuitry (320) to process the query to search the memory circuitry (330), the digital twin processing circuitry (320) to identify at least a first snapshot (600) and a second snapshot (600) in response to the query, the digital twin processing circuitry (320) to determine a correlation between the first snapshot (600) and the second snapshot (600) and generate a result with an actionable output based on the correlation.

2. The apparatus of claim 1, wherein the first snapshot (600) represents the interconnected plurality of digital twin models at a first point in time and wherein the second snapshot (600) represents the plurality of digital twin models at a second point in time.

3. The apparatus of claim 1 or 2, wherein the correlation includes at least one of i) a change from the first snapshot (600) to the second snapshot (600) over time or ii) a commonality between the first snapshot (600) and the second snapshot (600).

4. The apparatus of claim 3, wherein the commonality includes at least one of a related asset on a same airframe or a similar asset on a different airframe.

5. The apparatus of claim 3 or 4, wherein the change includes at least one of i) at least one of the first asset or the second asset moved from a first airframe to a second airframe, ii) a difference between a first configuration of the first asset and the second asset on the first airframe to a second configuration of the first asset and the second asset on the first airframe, or iii) a difference between the first configuration of the first asset and the second asset on the first airframe and a third configuration of the first asset and the second asset on the second airframe.

6. The apparatus of any preceding claim, wherein the plurality of digital twin models (101-132, 201) include at least one of an engine digital twin model (110-115), a landing gear digital twin model (120-122), a controller digital twin model, an airframe digital twin model, or an aircraft digital twin model (101-103).

7. The apparatus of claim 6, wherein the aircraft digital twin model (101-103) includes the engine digital twin model (110-115), the landing gear digital twin model (120-122), the controller digital twin model, and the airframe digital twin model.

8. The apparatus of claim 7, wherein the aircraft digital twin model (101-103) is part of a fleet of aircraft digital twin models (101-103).

9. The apparatus of any preceding claim, wherein the memory circuitry (330) includes a plurality of containers organizing the plurality of digital twin models (101-132, 201).

10. The apparatus of claim 9, wherein the actionable output includes at least one of i) triggering maintenance for at least one of the first asset or the second asset, ii) monitoring at least one of the first asset or the second asset, or iii) reconfiguring at least one of the first asset or the second asset.

11. The apparatus of any preceding claim, wherein the digital twin processing circuitry (320) is to process a change event to: ingest the change event, store a third snapshot (600) of the interconnected plurality of digital twin models (101-132, 201) based on the change event, and facilitate querying based on the change event.

12. The apparatus of claim 11, wherein the digital twin processing circuitry (320) includes an application program interface (405, 510) to facilitate ingestion of change events, storage of snapshots (600), and querying of the memory circuitry (330).

13. A method comprising:
processing, by executing an instruction (1332) using a processor (1312), a query to search a plurality of snapshots (600), each snapshot (600) including a plurality of digital twin models (101-132, 201) interconnected by a plurality of connections, the plurality of digital twin models (101-132, 201) including a first digital twin model (101-132, 201) of a first asset and a second digital twin model (101-132, 201) of a second asset, the plurality of connections including a first connection between the first digital twin model (101-132, 201) and the second digital twin model (101-132, 201), the first connection representing a relationship between the first digital twin model (101-132, 201) and the second digital twin model (101-132, 201) at a specified point in time, each snapshot (600) representing a state of the digital twin models (101-132, 201) at the point in time;
identifying, by executing an instruction (1332) using the processor (1312), at least a first snapshot (600)and a second snapshot (600) in response to the query;
determining, by executing an instruction (1332) using the processor (1312), a correlation between the first snapshot (600)and the second snapshot (600); and
generating, by executing an instruction (1332) using the processor (1312), a result with an actionable output based on the correlation.

14. A non-transitory computer readable storage medium (1313, 1314, 1316, 1328) comprising instructions (1332) which, when executed, cause a processor (1312) to implement the method of claim 13.
